(19) Europäisches Patentamt
European Patent Office
Office européen des brevets

(11) Veröffentlichungsnummer: **0 652 241 A2**

# (12) EUROPÄISCHE PATENTANMELDUNG

(21) Anmeldenummer: **94116951.8**

(51) Int. Cl.[6]: **C08G 59/12**, //C08J3/03

(22) Anmeldetag: **26.10.94**

(30) Priorität: **08.11.93 DE 4338118**

(43) Veröffentlichungstag der Anmeldung:
**10.05.95 Patentblatt 95/19**

(84) Benannte Vertragsstaaten:
**BE DE FR GB IT NL**

(71) Anmelder: **BAYER AG**

**D-51368 Leverkusen (DE)**
Anmelder: **BAYER ANTWERPEN N.V.**
**Haven 507,**
**Scheldelaan 420**
**B-2040 Antwerpen (BE)**

(72) Erfinder: **Audenaert, Raymond, Dr.**
**Polderstraat 24**
**B-9920 Hamme (BE)**
Erfinder: **Kirchmeyer, Stephan, Dr.**
**Ernst-Ludwig-Kirchner-Strasse 45**
**D-51375 Leverkusen (DE)**
Erfinder: **Dhein, Rolf, Dr.**
**Deswatinesstrasse 30**
**D-47800 Krefeld (DE)**

## (54) Polymerharze und deren Verwendung.

(57) Die vorliegende Erfindung betrifft wasserlösliche oder in Wasser dispergierbare Polymerharze sowie deren Verwendung als Filmbildner in wäßrigen Schlichtemitteln für Glasfasern, die dann Verwendung in flammwidrigen Formmassen finden.

EP 0 652 241 A2

Die vorliegende Erfindung betrifft wasserlösliche oder in Wasser dispergierbare Polymerharze sowie deren Verwendung als Filmbildner in wäßrigen Schlichtemitteln für Glasfasern, die dann Verwendung in flammwidrigen Formassen finden.

Kunststoffe sind organisch-chemische Verbindungen, die hauptsächlich aus Kohlenstoff und Wasserstoff bestehen und daher mehr oder weniger leicht brennbar sind. Fur viele ihrer zahlreichen Anwendungen müssen sie jedoch brandschutztechnischen Anforderungen genügen, die in gesetzlichen Vorschriften und einer Reibe anderer Regelwerke niedergelegt sind.

Die wichtigsten Anwendungsgebiete für flammgeschützte Kunststoffe umfassen das Barn- und Verkehrswesen sowie die Elektrotechnik. Weitere Anwendungsgebiete sind der Bergbau, Möbel und Einrichtungen, Bodenbeläge und Textilien.

Zur Brandschutzausrüstung von Polymeren werden sogenannte Flammschutzmittel verwendet, welche die Brandeigenschaften der Polymeren verbessern, jedoch die weiteren Kunststoffeigenschaften, wie beispielsweise die mechanischen Eigenschaften, nicht verändern sollen. Wirkung, Eigenschaften und Verwendung technisch üblicher Flammschutzmittel werden beispielsweise in J.H. Troitzsch, "Flammschutzmittel" im "Taschenbuch der Kunststoffadditive" herausgegeben von R. Gächter und H. Müller, Carl-Hanser-Verlag, München 1990, ausführlich beschrieben. Allerdings gibt es Flammschutzmittel mit idealem Eigenschaftsbild bislang nicht. Die wichtigsten Klassen von Flammschutzmitteln umfassen Aluminiumhydroxid, Antimonoxide, Borverbindungen, Halogenverbindungen und Phosphorverbindungen, wobei ihre Flammschutzwirkung stark vom zu schützenden Thermoplasten oder Duroplasten, dem sogenannten Matrixpolymer abhängig ist.

Für die Brandschutzausrüstung aromatischer thermoplastischer Polyester besitzen neben Antimontrioxid Brom-, Chlor- und Phosphorverbindungen wesentliche Bedeutung. Phosphor- und Halogenverbindungen sind vielseitig einsetzbar, besitzen jedoch neben der erwünschten Flammschutzwirkung unerwünschte Eigenschaften, wie beispielsweise weichmachende Wirkung, hohe Korrosivität und zweifelhafte Physiologie der Verbrennungsgase. Das von den Antimonverbindungen in der Praxis fast ausschließlich verwendete Antimontrioxid besitzt keine erkennbare Flammschutzwirkung, wenn es für sich allein eingesetzt wird. Nur wenn Antimonverbindungen zusammen mit halogenhaltigen Verbindungen verwendet werden, resultiert eine gute synergistische Wirkung.

Es existieren eine Reihe von Flammschutzprüfungen. Für den Elektrosektor besitzt die Prüfung nach UL 94 besondere Bedeutung. Die höchsten Anforderungen stellt die V-0-Klassifizierung. Die Summe der Nachbrennzeiten einer Serie von fünf Prüfkörpern mit je zwei Beflammungen von je 10 Sekunden darf 50 Sekunden nicht überschreiten, dabei darf kein Probekörper nach Beflammungsende länger als 10 Sekunden brennen und kein brennendes Abtropfen erfolgen. Zur Einstufung in Klasse V-1 darf die Summe der Nachbrennzeiten 250 Sekunden nicht überschreiten, kein Nachbrennen über 30 Sekunden und kein brennendes Abtropfen erfolgen. Findet unter den Bedingungen von V-1 brennendes Abtropfen statt, wird in Klasse V-2 eingestuft.

In der Praxis werden Formmassen häufig Glasfasern zugesetzt, welche die Werkstoffeigenschaften wie mechanische Festigkeit, Zähigkeit sowie Wärmestand positiv beeinflussen können. In Bezug auf Flammschutz gilt für glasfaserverstärkte Thermoplasten oder Duroplasten das Vorhergesagte gleichermaßen.

Zur Vermeidung der vorgenannten Nebenwirkungen von Flammschutzmitteln ist es hochgradig wünschenswert, die Menge der verwendeten Flammschutzmittel zu reduzieren, ohne die Flammschutzwirkung zu vermindern oder bei gleichem Flammschutzmittelgehalt eine höhere Flammschutzwirkung zu erzielen.

Aufgabe der Erfindung war es, flammgeschützte Formmassen zur Verfügung zu stellen, welche sich durch einen reduzierten Gehalt an Flammschutzmittel auszeichnen und trotzdem eine hervorragende Flammschutzwirkung besitzen bzw. bei gleichem Flammschutzmittelgehalt eine höhere Flammschutzwirkung aufweisen.

Überraschenderweise wurde gefunden, daß bei Verwendung von Glasfasern, welche mit einer Schlichte versehen wurden, die Polymerharze mit halogenorganischen und/oder phosphororganischen Struktureinheiten enthält, die Menge an Flammschutzmittel in den Formmassen drastisch reduziert werden kann, ohne daß die Flammschutzwirkung leidet, bzw. bei gleichem Flammschutzmittelgehalt eine weitaus bessere Flammschutzwirkung erzielt werden kann. Dies ist um so überraschender, als über die Glasfasern nur verschwindend geringe Mengen an Schlichte in die Formmassen eingetragen werden. Die Wirkung der eingesetzten Glasfasern übertrifft die Wirkung konventioneller Flammschutzmittel um ein Vielfaches.

Gegenstand der Erfindung sind wasserlösliche oder in Wasser dispergierbare Polymerharze, die dadurch gekennzeichnet sind, daß sie 10 bis 95 Gew.-% durch Einfachbindungen oder Alkylenketten mit 1 bis 10 Kohlenstoffatomen, Ester-, Ether-, Carbonat-, Amid-, Imid- und/oder Urethangruppen mit dem Polymerharz verbundene halogenorganische Struktureinheiten oder phosphororganische Struktureinheiten enthalten.

Bevorzugt sind wasserlösliche oder in Wasser dispergierbare Polymerharze, die dadurch gekennzeichnet sind, daß sie 10 bis 95 Gew.-% mindestens einer der folgenden Struktureinheiten (I) bis (VIII) enthalten, welche durch Einfachbindungen oder Alkylenketten mit 1 bis 10 Kohlenstoffatomen, Ester-, Ether-, Carbonat-, Amid-, Imid- und/oder Urethangruppen mit dem Polymerharz verbunden sind,

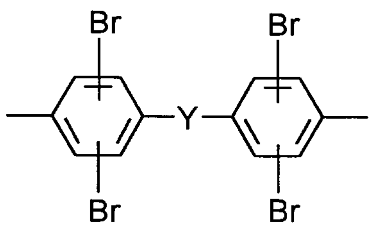 (I)

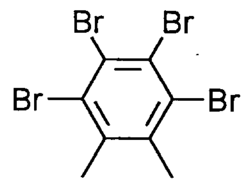 (II)

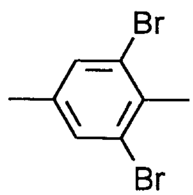 (III)

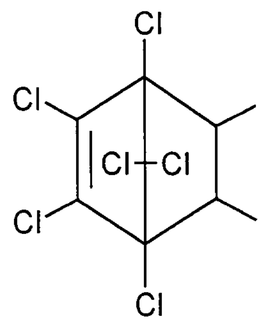 (IV)

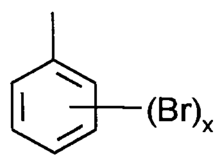 (V)

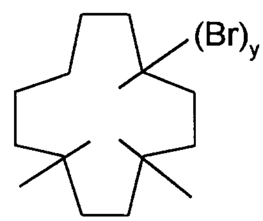 (VI)

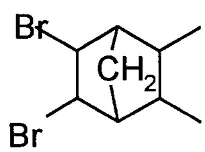 (VII)

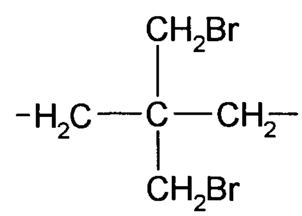 (VIII)

wobei

- Y einen Alkylen- oder einen Cycloalkylenrest mit 1 bis 10 Kohlenstoffatomen, -CO-, -O-, -S- oder $-SO_2-$ bedeutet und
- x ganze Zahlen von 1 bis 5 und
- y ganze Zählen von 1 bis 12 annehmen kann,

und/oder Struktureinheiten aus der Gruppe der Phosphine, Phosphinoxide, Phosphoniumverbindungen, Phosphinate, Phosphonate, Phosphite oder Phosphate enthalten.

Besonders bevorzugt sind wasserlösliche oder in Wasser dispergierbare Polymerharze, die dadurch gekennzeichnet sind, daß es sich bei dem Polymerharz um einen gegebenenfalls epoxidgruppenhaltigen Polyester handelt, erhältlich durch Kondensation bzw. Addition von

i) 6 bis 40 Gew.-% eines polyoxyalkylenmodifizierten Prepolymers,

ii) 60 bis 94 Gew.-% einer Epoxidgruppen enthaltenden Verbindung der allgemeinen Formel (IX)

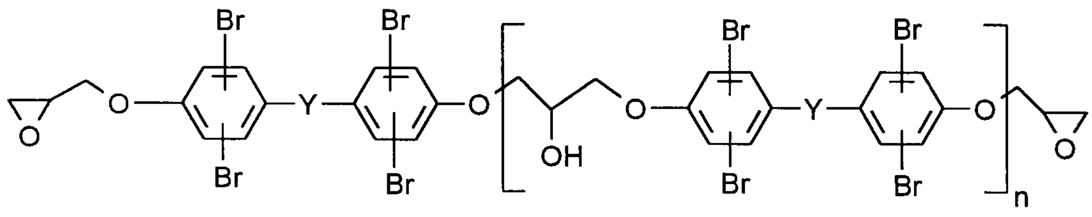

(IX)

wobei

Y die oben angegebene Bedeutung hat und

n eine Zahl von 0 bis ca. 6 bedeutet, und

iii) 0 bis 34 Gew.-% einer phenolische Hydroxylgruppen enthaltenden Verbindung der allgemeinen Formel (X) und/oder (XI)

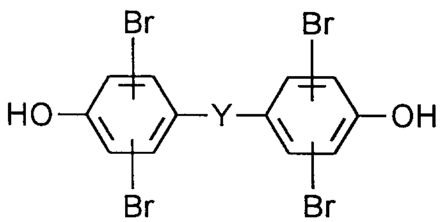 (X) 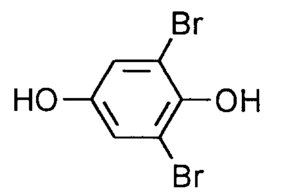 (XI)

wobei Y die oben angegebene Bedeutung hat.

Ein weiterer Gegenstand der Erfindung sind wäßrige Schlichtemittel für Glasfasern, enthaltend Filmbildner, Haftvermittler und gegebenenfalls weitere Zusatzstoffe, welche als Filmbildner die erfindungsgemäßen wasserlöslichen oder in Wasser dispergierbaren Polymerharze enthalten.

Ein weiterer Gegenstand der Erfindung sind Glasfasern, welche mit einem erfindungsgemäßen wäßrigen Schlichtemittel beschlichtet sind.

Das wäßrige Schlichtemittel wird üblicherweise während des Spinnprozesses auf die Glasfaser aufgebracht.

Ein weiterer Gegenstand der Erfindung sind flammwidrige Formmassen, welche

A) 30 bis 95 Gew.-% thermoplastisches oder duroplastisches Matrixpolymer,

B) 5 bis 70 Gew.-% erfindungsgemäß beschlichtete Glasfasern,

C) 0 bis 25 Gew.-% (bezogen auf das Matrixpolymer) eines oder mehrerer Flammschutzmittel und

D) 0 bis 10 Gew.-% übliche Zusatzstoffe und Hilfsmittel enthalten,

wobei die Summe der Gewichtsprozente aus A), B), C) und D) zusammen 100 % ergibt.

Bevorzugt enthalten die Formmassen als Matrixpolymer einen thermoplastischen aromatischen Polyester, ein thermoplastisches aromatisches Polycarbonat, ein Polyamid oder ein duroplastisch härtbares Epoxidharz.

Die erfindungsgemäßen wasserlöslichen oder in Wasser dispergierbaren Polymerharze enthalten durch Einfachbindungen oder Alkylenketten mit 1 bis 10 Kohlenstoffatomen, Ester-, Ether-, Carbonat-, Amid-, Imid- und/oder Urethangruppen mit dem Polymerharz verbundene halogenorganische Struktureinheiten oder phosphororganische Struktureinheiten. Halogenorganische Struktureinheiten sind allgemein Struktureinheiten, in welchen Halogenatome wie Chlor und Brom und weniger bevorzugt Fluor mit Kohlenstoffatomen von organischen Resten, z.B. mit aliphatischen, cycloaliphatischen, araliphatischen, aromatischen und/oder heterocyclischen Resten verbunden sind. Die organischen Reste können 1 bis 20 Kohlenstoffatome aufweisen und können durch Sauerstoff, Stickstoff und Schwefel unterbrochen bzw. substituiert sein. Bevorzugt handelt es sich bei den halogenorganischen Struktureinheiten um Struktureinheiten folgender Verbindungsklassen: aliphatische Bromverbindungen, aromatische Bromverbindungen und aliphatische Chlorverbindungen, wie z.B. Struktureinheiten der allgemeinen Formel (I),

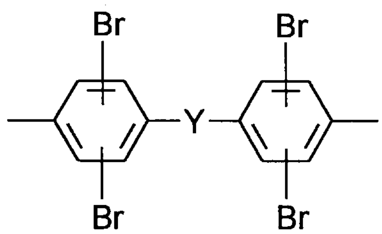

(I)

wobei

Y einen Alkylen- oder einen Cycloalkylenrest mit 1 bis 10 Kohlenstoffatomen, beispielsweise einen Methylen-, 1,1-Ethylen-, 2,2-Propylen-, 1,1-Cyclohexylen- oder 1,1-(3,3,5-Trimethyl)cyclohexylen-Rest, -CO-, -O-, -S- oder $-SO_2-$ bedeutet,

und der Formeln (II) bis (VIII)

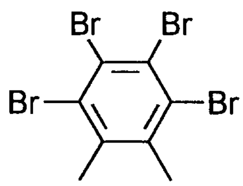

(II)

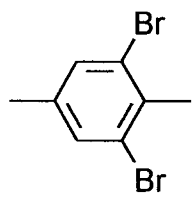

(III)

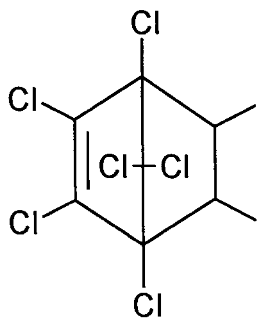

(IV)

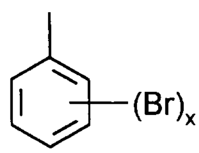

(V)

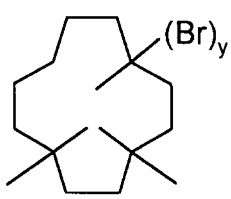

(VI)

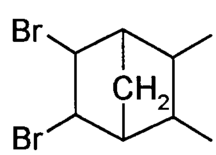

(VII)

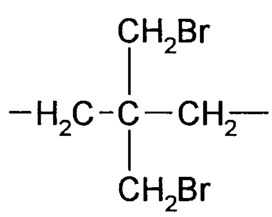

(VIII)

wobei

x ganze Zahlen von 1 bis 5 und

y ganze Zahlen von 1 bis 12

annehmen kann.

Phosphororganische Struktureinheiten sind Struktureinheiten, in denen Phosphoratome entweder über eine direkte Bindung oder durch Sauerstoffatome mit organischen Resten, z.B. mit aliphatischen, cycloaliphatischen, araliphatischen, aromatischen und/oder heterocyclischen Resten mit 1 bis 20 Kohlenstoffatomen verbunden sind, wie z.B. Phosphine, Phosphinoxide, Phosphoniumverbindungen, Phosphonsäureester, Phosphinsäureester, Phosphorsäureester, Ester der phosphorigen Säure, Phosphonigsäureester, Phosphinigsäureester sowie cyclische phosphororganische Struktureinheiten wie z.B. Phospholine und Phospholane.

Die halogenorganischen Struktureinheiten oder phosphororganischen Struktureinheiten sind in den erfindungsgemäßen Polymerharzen bevorzugt in einer Menge von 10 bis 95 Gew.-%, besonders bevorzugt von 30 bis 80 Gew.-%, enthalten.

Die erfindungsgemäßen wasserlöslichen oder in Wasser dispergierbaren Polymerharze enthalten neben halogenorganischen Struktureinheiten oder phosphororganischen Struktureinheiten hydrophile Gruppen in Form von anionischen oder kationischen Salzgruppen und/oder Polyoxyalkyleneinheiten, welche durch Einfachbindungen oder Alkylenketten mit 1 bis 10 Kohlenstoffatomen, Ester-, Ether-, Carbonat-, Amid-, Imid- und/oder Urethangruppen oder gegebenenfalls weiteren Gruppen mit dem Polymerharz verbunden sind.

Die hydrophilen Gruppen dienen bevorzugt dazu, das Polymer in Wasser löslich oder dispergierbar zu machen. Dies ist vorzugsweise dann der Fall, wenn

a) anionische oder kationische Salzgruppen in einer Menge von 5 bis zu 250, vorzugsweise bis zu 100 Milliäquivalenten pro 100 g Harz oder

b) Polyoxyalkylen-Einheiten in einer Menge von 5 bis zu 40 Gew.-% mit einem Anteil von Oxyethylen-Einheiten von mindestens 30 Gew.-% der Oxyalkylen-Einheiten

in den erfindungsgemäßen Polymerharzen enthalten sind. Sind Salzgruppen und Polyoxyethylen-Einheiten gleichzeitig in den erfindungsgemäßen Polymerharzen enthalten, sind Mengen an anionischen oder kationischen Salzgruppen von weniger als 5 Milliäquivalenten pro 100 g Harz und Mengen an Polyoxyethylen-Einheiten von weniger als 5 Gew.-% bevorzugt.

Als anionische Salzgruppen sind beispielsweise Carboxyl- und/oder Sulfonsäure- und/oder Phosphorsäuregruppen, welche mit einer geeigneten Base wie z.B. Natriumhydroxid, Kaliumhydroxid, Ammoniak oder Aminen wie Triethylamin oder N,N-Diethylethanolamin neutralisiert wurden, geeignet. Als weitere anionische Salzgruppen sind beispielsweise auch neutralisierte Cyanharnstoffgruppen geeignet, wie sie z.B. durch Umsetzung von Cyanamid mit Isocyanaten und Neutralisation mit tert. Aminen erhalten werden (s. DE-A 3 441 934). Geeignete kationische Salzgruppen sind z.B. Ammoniumgruppen, wie sie durch Neutralisation von tert. Aminen mit geeigneten Säuren wie z.B. Salzsäure, Phosphorsäure, Essigsäure oder Milchsäure erhalten werden können.

Zusätzlich zu den hydrophilen Gruppen können den erfindungsgemäßen, wasserlöslichen oder in Wasser dispergierbaren Polymerharzen vorzugsweise Hilfsmittel zugesetzt werden. Diese Hilfsmittel wirken der Koagulation der in Dispersion vorliegenden Polymerteilchen entgegen und erhöhen dadurch die Stabilität der Dispersion oder führen zu einer besseren Dispergierbarkeit des Polymerharzes. Bei den Hilfsmittel handelt es sich im allgemeinen um anionische, kationische oder neutrale niedermolekulare, oligomere oder polymere Emulgatoren, Tenside oder Schutzkolloide, die in einer Menge von 0 bis 40 Gew.-%, vorzugsweise 0 bis 20 Gew.-% bezogen auf die Masse des erfindungsgemäßen Polymerharzes in den wäßrigen Polymerdispersionen enthalten sein können.

Beispiele von anionischen niedermolekularen, oligomeren bzw. polymeren Emulgatoren oder Tensiden sind Alkali- oder Erdalkalisalze von Fettsäuren, z.B. Natriumsalze von gesättigten Fettsäuren mit 10 bis 21 Kohlenstoffatomen, Natriumsalze von ungesättigten Fettsäuren mit 12 bis 18 Kohlenstoffatomen, chlorsulfonierte und verseifte Paraffinöle, Alkylethersulfonate wie Ether von $\alpha$-Sulfo-$\omega$-hydroxy-polyethylenglykolen mit z.B. 1-Methylphenylethylphenol, Nonylphenol oder Alkylethern mit 12 bis 18 Kohlenstoffatomen, Arylalkylsulfonate wie beispielsweise mit geradkettigen oder verzweigten Butylgruppen versehene Naphthalinsulfonsäuren oder Alkylsulfate wie die Natriumsalze von langkettigen Schwefelsäurealkylestern.

Beispiele von kationischen niedermolekularen, oligomeren bzw. polymeren Emulgatoren oder Tensiden sind die Salze von langkettige Alkanresten tragenden Aminen mit 8 bis 22 Kohlenstoffatomen, die mit Säuren oder durch Alkylierung zu den Ammoniumverbindungen umgesetzt wurden, sowie analoge Phosphor- und Schwefelverbindungen.

Beispiele nichtionischer oligomerer bzw. polymerer Emulgatoren oder Tenside sind Alkylpolyglykolether oder -ester wie ethoxylierte gesättigte oder ungesättigte Bindungen tragende langkettige Alkohole z.B. mit 12 bis 18 Kohlenstoffatomen, ethoxyliertes Rizinusöl, ethoxylierte (Kokos)fettsäuren, ethoxyliertes Sojabohnenöl, ethoxylierte Resin- oder Rosinsäuren, ethoxylierter und gegebenenfalls propoxylierter Butyldiglykol oder ethoxylierte Alkylarylether wie ethoxyliertes geradkettiges und/oder verzweigtes Nonylphenol oder

Octylphenol oder benzyliertes p-Hydroxybiphenyl.

Geeignet als Emulgatoren oder Tenside sind weiterhin ethoxylierte langkettige Alkyl- oder Alkenylamine, Lecithin, mit langkettigen Alkylisocyanaten modifizierte Umsetzungsprodukte aus Polyethylenglykolen und Diisocyanaten, Umsetzungsprodukte von Rapsöl und Diethanol oder ethoxylierte Umsetzungsprodukte aus Sorbitan und langkettigen Alkan- oder Alkencarbonsäuren.

Geeignet sind schließlich sogenannte Schutzkolloide, wie z.B. Polyvinylalkohole oder wasserlösliche Cellulosederivate wie Methylcellulose.

Besonders bevorzugt sind die erfindungsgemäßen Polymerharze frei von externen Emulgatoren, Tensiden oder Schutzkolloiden. Die erfindungsgemäßen Harze können nach beliebigen Verfahren in eine in Wasser gelöste oder dispergierte Form gebracht werden, im einfachsten Falle durch Einrühren von Wasser oder durch Einrühren in Wasser, aber auch durch Anwendung hoher Scherkräfte oder mit Hilfe von Lösungsmitteln, welche nach dem Dispergier- bzw. Lösungsvorgang wieder entfernt werden, z.B. durch Destillation.

Die erfindungsgemäßen wasserlöslichen oder in Wasser dispergierbaren Polymerharze können neben halogenorganischen Struktureinheiten oder phosphororganischen Struktureinheiten weitere Struktureinheiten enthalten, welche durch Einfachbindungen oder Alkylenketten mit 1 bis 10 Kohlenstoffatomen, Ester-, Ether-, Carbonat-, Amid-, Imid- und/oder Urethangruppen oder gegebenenfalls weitere Gruppen mit dem Polymerharz verbunden sind und zum Aufbau des Polymerharzes dienen.

Es sind dies bevorzugt Reste von ethylenisch ungesättigten Verbindungen, Polyepoxiden, Polyisocyanaten, Polyalkoholen, Polyphenolen und Polycarbonsäuren oder deren Anhydriden, welche zum Aufbau von polymeren Strukturen dem Fachmann bekannt und geeignet sind. So ist es beispielsweise möglich, Etherstrukturen durch Umsetzung von Epoxiden mit Phenolen, Esterstrukturen durch Umsetzung von Carbonsäuren oder deren reaktionsfähigen Derivaten wie Carbonsäurechloriden oder -anhydriden mit Alkoholen, Phenolen oder phenolische Endgruppen tragenden Oligocarbonaten oder Umsetzung von Epoxiden mit Carbonsäuren, Urethanstrukturen durch Umsetzung von Isocyanaten mit Alkoholen oder Phenolen und Amid oder Imidstrukturen durch Umsetzung von Carbonsäurefunktionen mit Amin- oder Isocyanatfünktionen zu erzeugen. Weitere mögliche verbindende Gruppen sind z.B. Harnstoffgruppen, welche durch Umsetzung von Aminen mit Isocyanaten erhältlich sind.

Es ist auch möglich, die erfindungsgemäßen Polymerharze durch Polymerisation von ethylenisch ungesättigten Verbindungen zu erzeugen.

Zum Aufbau der erfindungsgemäßen Polymerharze bevorzugte ungesättigte Verbindungen sind Vinylverbindungen wie z.B. Ethylen, Propen, Buten, Styrol, Butadien, Isopren, Vinylacetat, Acrylate wie z.B. Methylacrylat, Ethylacrylat, Butylacrylat, Methylmethacrylat, Methacrylsäureglycidylester und Hydroxyethylmethacrylat, Amide wie z.B. Acrylamid, Methacrylamid, Säuren bzw. deren Derivate wie z.B. Acrylsäure, Methacrylsäure, Fumarsäure, Itaconsäure und Maleinsäureanhydrid, $\alpha$-Bromovinyldiethylphosphonat, $\alpha$-Carboethoxyvinyldiethylphosphonat, Isopropenyldimethylphosphonat, Vinyl-bis-(2-chloroethyl)phosphonat, Vinyldiethylphosphat und Phosphonsäure-$\alpha$-phenylvinylester.

Zum Aufbau der erfindungsgemäßen Polymerharze bevorzugte Epoxide sind mindestens eine Epoxidgruppe tragende Verbindungen mit 1 bis 20 C-Atomen, vorzugsweise Di- und Polyglycidylether bzw. -ester wie z.B. Polyglycidylether mehrwertiger Phenole, beispielsweise Brenzkatechin, Resorcin, Hydrochinon, 4,4'-Dihydroxydiphenyldimethylmethan, 4,4'-Dihydroxy-3,3'-dimethyl-diphenylpropan, 4,4'-Dihydroxydiphenylsulfon, Tris-(4-hydroxyphenyl)methan, von Chlorierungs- und Bromierungsprodukten der vorstehend genannten Polyphenole, von Novolaken (Umsetzungsprodukte von ein oder mehrwertigen Phenolen mit Aldehyden, insbesondere Formaldehyd, in Gegenwart saurer Katalysatoren); Phenyl-Epoxid-Verbindungen auf der Basis von aromatischen Aminen und Epichlorhydrin, beispielsweise N-Di(2,3-epoxypropyl)anilin, N,N'-Dimethyl-N,N'-diepoxypropyl-4,4'-diaminodiphenylmethan, N-Diepoxypropyl-4-aminophenylglycidylether (GB 722 830 und GB 816 923) und Glycidylester mehrwertiger aromatischer, aliphatischer Adipinsäurediglycidylester. Besonders bevorzugt ist der Bisglycidylether des 2,2',6,6'-Tetrabrombisphenol A.

Zum Aufbau der erfindungsgemäßen Polymerharze bevorzugte Phenole sind di- oder mehrfunktionelle Phenole wie z.B. Hydrochinon, 4,4'-Dihydroxydiphenyldimethylmethan, 4,4'-Dihydroxy-3,3'-dimethyl-diphenylpropan, 4,4'-Dihydroxydiphenylsulfon, Tris-(4-hydroxyphenyl)methan, Chlorierungs- und Bromierungsprodukte der vorstehend genannten Polyphenole und Novolake, Hydroxylfunktionen tragende Oligocarbonate auf der Basis von 2,2'-6,6'-Tetrabrombisphenol A oder Oligo-1,6-dibromoxyphenylene. Besonders bevorzugt ist 2,2'-6,6'-Tetrabrombisphenol A.

Zum Aufbau der erfindungsgemäßen Polymerharze bevorzugte Alkohole sind di- oder mehrfunktionelle Alkohole wie z.B. Ethylenglykol, Propylenglykol-(1,2) und -(1,3), Butylenglykol-(1,4) und -(2,3), Hexandiol-(1,6), Octandiol-(1,8), Neopentylglykol, Dibromneopentylglykol, 1,4-Bis-(hydroxymethyl)cyclohexan, 2-Methyl-1,3-propandiol, Glycerin, Trimethylolpropan, Hexantriol-(1,2,6), Butantriol-(1,2,4), Trimethylolethan und

Pentaerythrit, ferner Di-, Tri-, Tetra- und höhere Polyethylenglykole, Di- und höhere Polypropylenglykol sowie Di- und höhere Polybutylenglykole. Es können auch di- oder polyfunktionelle Alkohole mit einem Molekulargewicht in der Regel von 400 bis 10.000, bevorzugt solche vom Molekulargewicht 400 bis 2.000, wie z.B. Polyester-, Polyether- oder Polycarbonatpolyole mitverwendet werden.

Zum Aufbau der erfindungsgemäßen Polymerharze bevorzugte Carbonsäuren bzw. deren reaktionsfähige Derivate sind aliphatische, alicyclische, aromatische oder heterocyclische Di- oder Polycarbonsäuren, deren Anhydride oder Säurehalogenide. Geeignet sind beispielsweise Cyclohexan-1,2, -1,3- oder -1,4-dicarbonsäure, Bernsteinsäure und deren Anhydrid, Adipinsäure, Maleinsäure und deren Anhydrid, Fumarsäure, Phthalsäure und deren Anhydrid, Tetrabromphthalsäure und deren Anhydrid, Isophthalsäure oder Terephthalsäure. Besonders bevorzugt sind Phthalsäure, Phthalsäureanhydrid, Tetrabromphthalsäure bzw. Tetrabromphthalsäureanhydrid.

Zum Aufbau der erfindungsgemäßen Polymerharze bevorzugte Isocyanate sind aliphatische, cycloaliphatische, araliphatische, aromatische und heterocyclische Polyisocyanate, wie sie z.B. in HOUBEN-WEYL "Methoden der organischen Chemie", Band E20 "Makromolekulare Stoffe", Herausgeber H. Bartl, J. Falbe, Georg Thieme Verlag, Stuttgart, New York 1987, S. 1587-1593, beschrieben werden, z.B. 1,6-Hexamethylendiisocyanat, 1,12-Dodecandiisocyanat, Cyclohexan-1,3- und -1,4-Diisocyanat sowie beliebige Gemische dieser Isomeren, 1-Isocyanato-3,3,5-trimethyl-5-isocyanatomethyl-cyclohexan, 2,4- und 2,6-Hexahydrotoluylendiisocyanat sowie beliebige Gemische dieser Isomeren, Hexahydro-1,3- und/oder -1,4-phenylendiisocyanat, Perhydro-2,4'- und/oder -4,4'-diphenylmethandiisocyanat, 1,3- und 1,4-Phenylendiisocyanat, 2,4- und 2,6-Toluylendiisocyanat sowie beliebige Gemische dieser Isomeren, Diphenylmethan-2,4'- und/oder -4,4'-diisocyanat.

Zum Aufbau der erfindungsgemäßen Polymerharze können auch Amine mitverwendet werden, beispielsweise zur Kettenverlängerung von Polyurethanprepolymeren unter Bildung von Harnstoffstrukturen oder zur Einführung der anionischen oder kationischen Salzgruppen.

Bei der Auswahl der mm polymeren Aufbau dienenden Ausgangsverbindungen ist folgende Regel zu beachten, um unerwünschte Vernetzungsreaktionen zu vermeiden, da Vernetzungsreaktionen insbesondere die Löslichkeit oder Dispergierbarkeit der erfindungsgemäßen Harze verschlechtern:

Die mittlere Funktionalität F der Ausgangsverbindungen darf einen Wert von 2 nicht überschreiten. Die mittlere Funktionalität berechnet sich aus der Summe der Produkte aus Molzahl $n_i$ und der Funktionalität $F_i$ des jeweiligen Bausteins geteilt durch die Summe der Molzahlen $n_i$. Dies wird durch die folgende Formel ausgedrückt:

$$F = \Sigma (F_i \, . \, n_i)/\Sigma n_i \leqq 2$$

Das bedeutet z.B., daß tri- oder polyfunktionelle Bausteine durch entsprechende Mengen an monofunktionellen Bausteinen ausgeglichen werden müssen, um Vernetzungen zu vermeiden.

Besonders bevorzugt handelt es sich bei dem erfindungsgemäßen Polymerharz um einen gegebenenfalls epoxidgruppenhaltigen Polyester, erhältlich durch Kondensation bzw. Addition von

i) 6 bis 40 Gew.-% eines säuregruppenhaltigen polyoxyalkylenmodifizierten Prepolymers und

ii) 60 bis 94 Gew.-% einer oder mehrerer Epoxidgruppen enthaltender Verbindungen der allgemeinen Formel (IX)

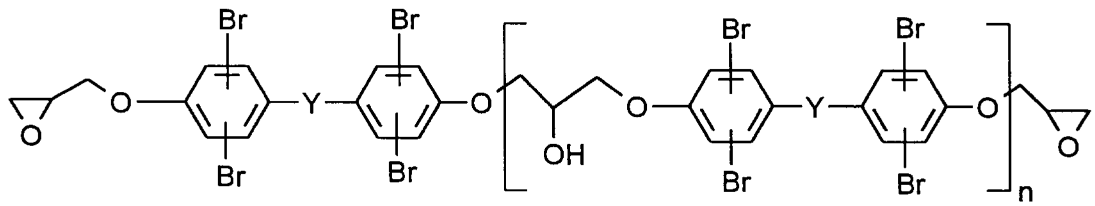

(IX)

wobei

| | |
|---|---|
| Y | die oben angegebene Bedeutung hat und |
| n | eine Zahl von 0 bis ca. 6 bedeutet, |

und

iii) 0 bis 34 Gew.-% einer phenolische Hydroxylgruppen enthaltenden Verbindung der allgemeinen Formel (X) und/oder (XI),

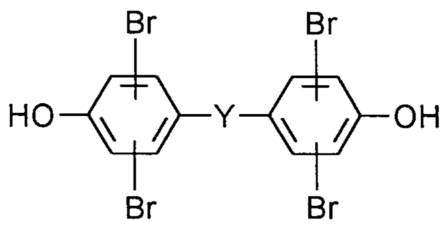 (X) 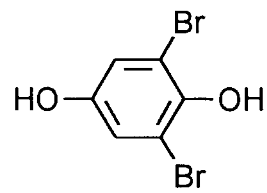 (XI)

wobei Y die oben angegebene Bedeutung hat.

Die säuregruppenhaltigen polyoxyalkylenmodifizierten Prepolymere werden vorzugsweise hergestellt durch Veresterung von polyoxyethylen-, polyoxypropylen- bzw. gegebenenfalls höhere polyoxyalkylenhaltigen Polyalkoholen und Dicarbonsäuren oder deren veresterungsfähigen Derivaten sowie gegebenenfalls weiteren Diolen in an sich bekannter Weise (vgl. z.B. Houben-Weyl, Methoden der Organischen Chemie, Stuttgart, 1963, Bd. 14/2, S. 1-5, 21-23, 40-44; C. Martens, Alkyd-Resins, Reinhold Publ. Comp. 1961, Reinhold Plastics Appl. Ser., S. 51-59) bis auf Säurezahlen von 5 bis 200, bevorzugt 30 bis 100 mg KOH/g. Es ist ebenfalls möglich, Monocarbonsäuren und Monoalkohole mit einzusetzen. Sie werden zusammen oder getrennt in einer oder mehreren Stufen mit einer oder mehreren der Epoxidgruppen enthaltenden Verbindungen gemäß der allgemeinen Formel (V) und einer oder mehreren phenolischen Hydroxylgruppen enthaltenden Verbindungen gemäß der allgemeinen Formel (V) und (VI), bei Temperaturen zwischen 20 und 200 °C, bevorzugt zwischen 80 und 150 °C zum erfindungsgemäßen Polymerharz umgesetzt. Die Prepolymerherstellung und die Epoxyaddition können in beliebiger Reihe durchgeführt werden. In einer speziellen Ausführungsform werden die polyoxyalkylenmodifizierten Prepolymere mit einer oder mehreren der oben beschriebenen Epoxidgruppen enthaltenden Verbindungen so umgesetzt, daß nach der Reaktion noch eine Restsäurezahl von 0,5 bis 20, vorzugsweise 4 bis 10 mg KOH/g verbleibt.

Die erfindungsgemäßen Schlichtemittel enthalten die erfindungsgemäßen Polymerharze in Form von wäßrigen Lösungen oder wäßrigen Dispersionen und können weitere Komponenten wie Emulgatoren, weitere filmbildende Harze, Haftvermittler, Gleitmittel und Hilfsstoffe wie Netzmittel oder Antistatika enthalten. Die Haftvermittler, Gleitmittel und Hilfsstoffe, das Verfahren zur Herstellung, das Verfahren der Beschlichtung und die Nachbearbeitung der Glasfasern ist bekannt und beispielsweise in K.L. Loewenstein, "The Manufacturing Technology of Continuous Glass Fibres", Elsevier Scientific Publishing Corp., Amsterdam, London, New York, 1983, beschrieben.

Als weitere filmbildende Harze sind in Wasser dispergierbare, emulgierbare oder lösliche Polymer geeignet. Beispiele sind Polyesterpolymere oder Epoxidgruppen enthaltende Polyesterpolymere, Polyurethane, Acrylpolymere, Vinylpolymere wie Polyvinylacetat, Mischungen solcher Polymere und Copolymere von entsprechenden Monomeren. Die Konzentration der filmbildenden Harze in den erfindungsgemäßen Schlichtemitteln beträgt vorzugsweise 1 bis 12 Gew.-%, besonders bevorzugt 2 bis 8 Gew.-%. Der Anteil des erfindungsgemäßen Polymerharzes an der Gesamtheit der filmbildenden Harze beträgt vorzugsweise 10 bis 100 Gew.-%, besonders bevorzugt 50 bis 100 Gew.-%.

Als Haftvermittler werden z.B. die bekannten Silan-Haftvermittler verwendet, beispielsweise 3-Aminopropyltrimethoxy- bzw. -triethoxysilan, N-(2-Aminoethyl)-3-aminopropyltrimethoxysilan, 3-Glycidylpropyltrimethoxysilan, Vinyltrimethoxysilan, Vinyltriethoxysilan oder 3-Methacryloxypropylthethoxysilan. Die Konzentration der Silanhaftvermittler in den erfindungsgemäßen Schlichtemitteln beträgt bevorzugt 0,05 bis 2 Gew.-%, besonders bevorzugt 0,15 bis 0,85 Gew.-%, bezogen auf die gesamte Schlichte.

Die erfindungsgemäßen Schlichtemittel können ein oder mehrere nichtionische und/oder ionische Gleitmittel enthalten, die z.B. aus folgenden Stoffgruppen bestehen können:

Polyalkylenglykolether von Fettalkoholen oder Fettaminen, Polyalkylenglykolether und Glycerinester von Fettsäuren mit 12 bis 18 Kohlenstoffatomen, Polyalkenylglykole, höhere Fettsäureamide mit 12 bis 18 Kohlenstoffatomen von Polyalkenylglykolen und/oder Alkenylaminen, quartäre Stickstoffverbindungen, z.B. ethoxylierte Imidazoliniumsalze, Mineralöle und Wachse. Das oder die Gleitmittel werden bevorzugt in einer Gesamtkonzentration zwischen 0,05 und 1,5 Gew.-%, bezogen auf die gesamte Schlichte, angewendet.

Daneben können die erfindungsgemäßen Schlichtemittel noch ein oder mehrere Antistatika, wie z.B. Lithiumchlorid, Ammoniumchlorid, Cr-III-salze, organische Titanverbindungen, Arylalkylsulfate- oder Sulfonate, Arylpolyglykolethersulfonate oder quartäre Stickstoffverbindungen, enthalten. Die Antistatika werden

bevorzugt in Konzentrationen von 0,01 bis 0,8 Gew.-% angewendet.

Für die beschlichteten Glasfasern sind sowohl die für die Glasseidenfabrikation verwendeten, bekannten Glastypen, wie E-, A-, C- und S-Glas, als auch die bekannten Glasstabelfasererzeugnisse geeignet. Unter den genannten Glastypen für die Herstellung von Endlosglasfasern besitzen die E-Glasfasern aufgrund ihrer Alkalifreiheit, hoher Zugfestigkeit und hohen Elastizitätsmodul die größte Bedeutung für die Verstärkung von Kunststoffen.

Die Schlichten können über beliebige Methoden appliziert werden, beispielsweise mit Hilfe geeigneter Vorrichtungen, wie z.B. Sprüh- oder Walzenapplikatoren. Sie werden auf die mit hoher Geschwindigkeit aus Spinndüsen gezogenen Glasfilamente sofort nach deren Erstarren, d.h. noch vor dem Aufwickeln, aufgetragen. Es ist aber auch möglich, die Fasern im Anschluß an den Spinnprozeß in einem Tauchbad zu beschlichten. Die beschlichteten Glasfasern können entweder naß oder trocken beispielsweise zu Schnittglas weiterverarbeitet werden. Die Trocknung des End- oder Zwischenproduktes findet bei Temperaturen von 90 bis 150 °C statt. Unter Trocknung ist dabei nicht allein die Entfernung von Wasser und anderen flüchtigen Bestandteilen zu verstehen, sondern z.B. auch das Festwerden der Schlichtebestandteile. Erst nach beendeter Trocknung hat sich die Schlichte in die fertige Überzugsmasse verwandelt. Der Anteil der Schlichte beträgt, bezogen auf die beschlichteten Glasfasern, bevorzugt 0,1 bis 2,0 Gew.-%, besonders bevorzugt 0,5 bis 1,5 Gew.-%.

Als Matrixpolymere können in den erfindungsgemäßen Formmassen eine Vielzahl von Thermoplasten bzw. duroplastisch härtbaren Polymern verwendet werden. Beispielsweise sind als thermoplastische Polymere geeignet: Polyolefine wie Polyethylen oder Polypropylen, Polyvinylchlorid, Polymerisate wie Styrol/-Acrylnitril-Copolymere, ABS, Polymethylmethacrylat oder Polyoxymethylen, aromatische und/oder aliphatische Polyamide wie Polyamid-6 oder Polyamid-6,6, Polykondensate wie Polycarbonat, Polyethylenterephthalat, Polybutylenterephthalat, flüssigkristalline Polyarylester, Polyarylenoxid, Polysulfon, Polyarylensulfid, Polyarylsulfon, Polyethersulfon, Polyarylether oder Polyetherketon oder Polyaddukte wie Polyurethane. Als duroplastisch härtbare Polymere seien beispielsweise genannt: Epoxidharze, ungesättigte Polyesterharze, Phenolharze, Aminharze, Polyurethanharze, Polyisocyanurate, Epoxid/Isocyanurat-Kombinationsharz, Furanharze, Cyanuratharze und Bismaleimidharze.

Bevorzugt sind Polyester wie Polyethylenterephthalat und Polybutylenterephthalat, Polycarbonat, Polyamide wie Polyamid-6 und Polyamid-6,6 und duroplastisch härtbare Polymere wie Epoxidharze und Epoxid/Isocyanurat-Kombinationsharze.

Geeignete Flammschutzmittel für die erfindungsgemäßen Formmassen sind solche, welche den Verbrennungsprozess hemmen und im günstigsten Fall unterbinden. Sie können je nach ihrer Beschaffenheit eine physikalische Wirkung wie z.B. Kühlung, Ausbildung einer Schutzschicht oder Verdünnung durch inerte Gase und/oder eine chemische Wirkung wie z.B. Abbruch der in der Gasphase stattfindenden radikalischen Kettenreaktionen oder Ausbildung einer verkohlten Schicht auf der Oberfläche des Polymeren aufweisen.

Einzelheiten über die Wirkung geeigneter Flammschutzmittel, ihre Eignung für verschiedene Polymerklassen und anwendungstechnische Hinweise finden sich beispielsweise in J.H. Troitzsch "Flammschutzmittel" im "Taschenbuch der Kunststoff-Additive", herausgegeben von R. Gächter und H. Müller, Hanser Verlag, München, Wien 1990.

Geeignete Flammschutzmittel sind z.B. halogenierte Verbindungen wie Decabromdiphenylether, Octabromdiphenylether, Pentabromdiphenylether, Hexabromdiphenoxyethan, Tetrabromphthalsäureanhydrid, Tetrabromphthalsäurediole und -polyether, Ethylen-bis-tetrabromphthalimid, 2,2',6,6'-Tetrabrombisphenol A (TBBA), TBBA-bis-(2,3-dibrompropylether), TBBA-bis-(2-hydroxyethylether), TBBA-bis-(allylether), TBBA-bis-(2-ethyletheracrylat), TBBA-Carbonat-Oligomere, bromierte Epoxidharze auf Basis TBBA, Poly-(dibromphenylenether), Poly(pentabrombenzylacrylat), Poly(tribromstyrol), Hexabromcyclododecan, Ethylen-bis-(dibromonorbornan-di-carboximid), Dibromethyldibromcyclohexan, Di-bromneopentylglykol, Chlorparaffine, Hexachlorendomethylentetrahydrophthalsäure bzw. deren Anhydrid und fluorierte Stoffe wie Perfluorbutansulfonsäure-Natriumsalzund Poly(tetrafluorethylen). Geeignet sind auch Antimonverbindungen wie z.B. Antimonoxid, welche erst in Kombination mit halogenhaltigen Verbindungen ihre flammhemmende Wirkung entfalten.

Geeignet sind auch phosphorhaltige Flammschutzmittel wie z.B. Phosphine, Phosphinoxide, Phosphoniumverbindungen, Phosphonate, elementarer roter Phosphor, Phosphite, Phosphate wie Arylphosphate und alkylsubstituierte Arylphosphate und Phosphorinane.

Geeignet sind weiterhin anorganische Verbindungen wie z.B. Aluminiumhydroxid, Magnesiumhydroxid und borhaltige Verbindungen wie Borsäure, und Zinkborat oder Kalium- bzw. Natriumtetrafluorborat.

Die erfindungsgemäßen Formmassen enthalten 30 bis 95 Gew.-% thermoplastisches oder duroplastisch härtbares Polymer, 5 bis 70 Gew.-% erfindungsgemäß beschlichtete Glasfasern, 0 bis 25 Gew.-% eines oder mehrerer Flammschutzmittel und übliche Zusatzstoffe und Hilfsmittel. Die Menge der maximal

einsetzbaren Glasfasern richtet sich nach den Eigenschaften des Matrixpolymers und ist bei Thermoplasten vorwiegend von der Schmelzviskosität des Polymers abhängig. Bevorzugt sind, insbesondere für Thermoplasten mit höherer Schmelzviskosität, Füllgrade von ca. 5 bis 30 %. Duroplastisch härtbaren Harzen können aufgrund der geringen Viskosität der Harze in wesentlich höherem Umfang Glasfasern zugesetzt werden.

Die erfindungsgemäßen Formmassen aus thermoplastischen oder duroplastisch härtbaren Polymeren und Glasfasern können über beliebige Methoden hergestellt werden. Thermoplastische Formmassen können beispielsweise dadurch hergestellt werden, indem man die beschlichteten Glasfasern in Form von Schnittglas ("chopped strands"), Rovings oder Kurzglas in Extrudern mit dem aufgeschmolzenen Thermoplasten vermischt, zu Strängen verpreßt und zu Kunststoffgranulat verarbeitet. Dieses Kunststoffgranulat dient als Ausgangsbasis zur Herstellung von Formteilen und Gegenständen aus glasfaserverstärktem thermoplastischem Kunststoff. Duroplastisch härtbare Formmassen können nach den üblichen Technologien für durplastische Formmassen hergestellt und verarbeitet werden, beispielsweise durch Imprägnieren von Schnitt- oder Endlosglasfasern oder Glasgeweben, -gestricken, -gewirken oder -gelegen zu SMC (sheet-moulding-compounds) und BMC (bulk-moulding-compounds) und anschließende Formgebung unter Härtung z.B. durch Gießen, Pressen, Spritzgießen, Schleudergießen, Wickeln oder Pultrusion. Einzelheiten zur Herstellung und Verarbeitung duroplastisch härtbarer Formmassen sind dem Fachmann bekannt und beispielsweise beschrieben in J.G. Mohr "SPI Handbook of Technology and Engineering of Reinforced Plastics/Composites", Van Nostrand Reinhold Company, New York, 1973.

Es können den Formmassen übliche Zusatzstoffe und Hilfsmittel, beispielsweise weitere Füllstoffe, Stabilisatoren, Pigmente oder Farbstoffe zugesetzt werden. Als derartige Stoffe kommen beispielsweise Calciumcarbonat, Talkum, Kieselgel, Bariumsulfat, Calciumsulfat, Kaolin, Bentonit, Eisenoxide, Titandioxid, Zeolithe, Wollastonit, Dolomit, Zinkoxid, Magnesiumcarbonat, Molybdendisulfid, gemahlenes Glas, Glaskugeln, Quarzmehl oder Mischungen hiervon in Betracht. Weitere faserförmige Füllstoffe sind beispielsweise Aramidfasern, Kohlenstoffasern, Metallfasern oder Keramikfasern. Weitere Additive umfassen zum Beispiel Entformungsmittel, Gleitmittel, Alterungsschutzmittel oder Nukleierungsmittel. Thermoplastischen Formmassen können zudem weitere Polymere als Blendpartner zugesetzt werden.

Die erfindungsgemäßen Formmassen können auf übliche Weise zu Form-, Preß- und Spritzgußteilen, Thermoformteilen, Halbzeugen, Platten wie z.B. Leiterplatten, Behältern, Geräte- und Fahrzeugteilen, Gehäusen, Rollen, Zahnrädern, Maschinenteilen, Fasern, Folien, Profilen und Walzen verarbeitet werden. Die erfindungsgemäßen Formmassen können generell in vorteilhafter Weise dort eingesetzt werden, wo thermoplastisch verarbeitbare oder duroplastisch härtbare Massen eingesetzt werden.

Die vorliegende Erfindung soll anhand der nachfolgenden Beispiele näher erläutert werden.

**Beispiel 1** (Herstellung eines erfindungsgemäßen Polymerharzes)

In einem 5 1-Dreihalskolben mit Innenthermometer und mechanischer Rührung werden 2.760 g eines Polyethylenglykols mit einer Hydroxylzahl von 56 mg KOH/g und 408,5 g Phthalsäureanhydrid auf 100 °C erhitzt und 12 Stunden bei 100 °C und 12 Stunden bei 120 °C gerührt. Die Schmelze besitzt anschließend eine Säurezahl von 52 mg KOH/g. Die Temperatur wird auf 100 °C gesenkt. Es werden 4.995,6 g Tetrabrombisphenol A-Bisglycidylether und 23 g Natriumcarbonat zugegeben und bis zu einer Säurezahl von 0 mg KOH/g nachgerührt. Die Temperatur wird auf 140 °C angehoben, 1.035,9 g Tetrabrombisphenol A zugegeben und 3 Stunden bei dieser Temperatur nachgerührt. Die Temperatur wird auf 100 °C gesenkt und 21,44 l 90 °C heißes deionisiertes Wasser langsam zugegeben. Die Mischung wird unter Rühren abgekühlt. Man erhält eine feinteilige Polymerdispersion mit folgenden Daten: Feststoffgehalt 40 Gew.-%, Viskosität bei 25 °C 8.000 mPa.s, Dichte 1,09 g/ml, pH 4 bis 5. Die Dispersion enthält im Harz ca. 56 Gew.-% Struktureinheiten der allgemeinen Formel (I).

**Beispiel 2** (Herstellung einer erfindungsgemäßen Glasfaser)

Die Schlichte der Glasfasern setzt sich folgendermaßen zusammen:

| Schlichtekomponente | Gewichts-% |
|---|---|
| γ-Aminopropyltriethoxysilan | 0,5 |
| wasserdispergiertes Polymerharz gemäß Beispiel 1 | 5,0 |
| Polyalkylenglykol | 0,5 |
| Wasser | 94,0 |

Die Schlichte wird über einen Kiss-rollapplikator auf Glasfasern mit einem Durchmesser von 10 µm aufgebracht. Die Glasfasern werden zu Cakes (Bobinen) gewickelt und anschließend 10 Stunden bei 130 °C getrocknet. Die Glasfasern werden nach der Trocknung in 4,5 mm lange Chops geschnitten.

**Beispiel 3** (Herstellung der erfindungsgemäßen Formmassen und Vergleich)

Verwendete Komponenten

A) Polybutylenterephthalat (Pocan B 4235; Handelsprodukt der BAYER AG)
B1) Für Polybutylenterephthalat geeignete Glasfaser gemäß EP-A 27 942
B2) Glasfaser gemäß Beispiel 2
C) Tetrabrombisphenol A-Carbonat-Oligomer

Polybutylenterephthalat (A) und die Komponente (C) werden gemischt und auf einem kontinuierlich arbeitenden Doppelwellenextruder aufgeschmolzen. Über einen Dosiertrichter werden jeweils die Glasfasern (B) in die Schmelze dosiert. Die Zylindertemperaturen werden dabei so gewählt, daß Massetemperaturen von 280 bis 330 °C eingehalten wurden. Der Schmelzestrang wird in Wasser abgeleitet, granuliert und getrocknet.

Von den Formmassen werden auf einer üblichen Spritzgußmaschine 127 x 12,7 x 1,6 mm-Prüfstäbe hergestellt. Geprüft wird die Flammfestigkeit nach UL 94, (Senkrechttest zur Einstufung in die Klassen V-0, V-1 und V-2).

Tabelle 1

| Zusammensetzung der Formmassen (Angaben in Gew.-%) | | | | | |
|---|---|---|---|---|---|
| Komponente Nr. | A | B1 | B2 | C | Flammfestigkeit nach UL 94 |
| Beispiel 3.1$^{+)}$ | 63 | 30 | - | 7 | V-0 |
| Beispiel 3.2$^{+)}$ | 64,4 | 30 | - | 5,6 | V-2 |
| Beispiel 3.3 | 64,4 | - | 30 | 5,6 | V-0 |

$^{+)}$ nicht erfindungsgemäß

Aus den Beispielen 3.1 und 3.2 geht hervor, daß bei Reduzierung des Flammschutzmittels die Flammschutzwirkung in einer ansonsten identischen Formmasse zurückgeht. Durch Zusatz der erfindungsgemäßen Glasfasern (Beispiel 3.3) wird trotz Reduzierung des Flammschutzmittels wieder eine Flammfestigkeit von V-0 erreicht. Die Formmasse 3.3 weist also gegenüber der Formmasse 3.1 einen geringeren Flammschutzmittelgehalt bei gleicher Flammfestigkeit und gegenüber der Formmasse 3.2 eine verbesserte Flammschutzwirkung bei gleichem Gehalt an Flammschutzmittel auf.

**Patentansprüche**

1. Wasserlösliche oder in Wasser dispergierbare Polymerharze, dadurch gekennzeichnet, daß sie 10 bis 95 Gew.-% durch Einfachbindungen oder Alkylenketten mit 1 bis 10 Kohlenstoffatomen, Ester-, Ether-, Carbonat-, Amid-, Imid- und/oder Urethangruppen mit dem Polymerharz verbundene halogenorganische

Struktureinheiten oder phosphororganische Struktureinheiten enthalten.

2. Wasserlösliche oder in Wasser dispergierbare Polymerharze gemäß Anspruch 1, dadurch gekennzeichnet, daß sie 10 bis 95 Gew.-% mindestens einer der folgenden Struktureinheiten (I) bis (VIII) enthalten, welche durch Einfachbindungen oder Alkylenketten mit 1 bis 10 Kohlenstoffatomen, Ester-, Ether-, Carbonat-, Amid-, Imid- und/oder Urethangruppen mit dem Polymerharz verbunden sind,

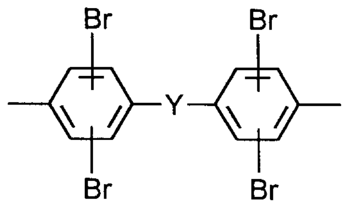
(I)

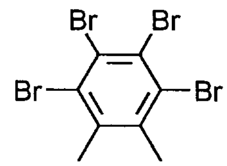
(II)

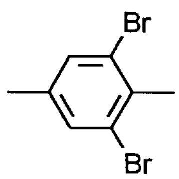
(III)

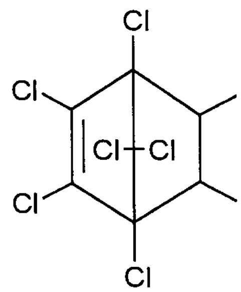
(IV)

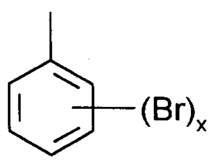
(V)

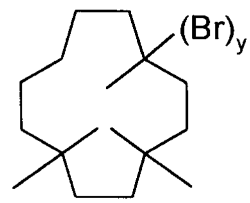
(VI)

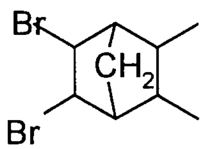
(VII)

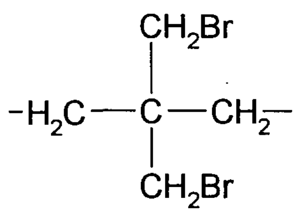
(VIII)

wobei

- Y einen Alkylen- oder einen Cycloalkylenrest mit 1 bis 10 Kohlenstoffatomen, -CO-, -O-, -S- oder $-SO_2-$ bedeutet und
- x ganze Zahlen von 1 bis 5 und
- y ganze Zahlen von 1 bis 12 annehmen kann,

und/oder Struktureinheiten aus der Gruppe der Phosphine, Phosphinoxide, Phosphoniumverbindungen, Phosphinate, Phosphonate, Phosphite oder Phosphate enthalten.

3. Wasserlösliche oder in Wasser dispergierbare Polymerharze gemäß Anspruch 1 oder 2, dadurch gekennzeichnet, daß es sich bei dem Polymerharz um einen gegebenenfalls epoxidgruppenhaltigen Polyester handelt, erhältlich durch Kondensation bzw. Addition von
   i) 6 bis 40 Gew.-% eines polyoxyalkylenmodifizierten Polyesters mit einem Gehalt an Oxyethyleneinheiten, so daß der Anteil von Oxyethyleneinheiten am Gesamtharz mindestens 5 % beträgt,
   ii) 60 bis 94 Gew.-% einer Epoxidgruppen enthaltenden Verbindung der allgemeinen Formel (IX)

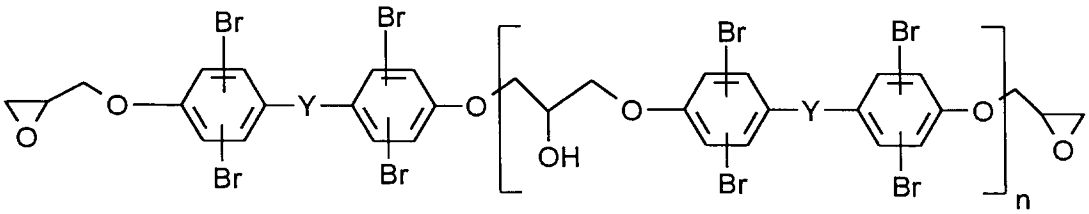

(IX)

wobei
Y die oben angegebene Bedeutung hat und
n eine Zahl von 0 bis ca. 6 bedeutet, und
iii) 0 bis 34 Gew.-% einer phenolische Hydroxylgruppen enthaltenden Verbindung der allgemeinen Formel (X) und/oder (XI)

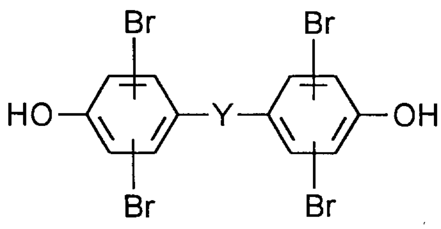

(X)

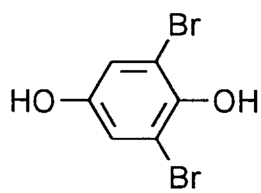

(XI)

wobei Y die oben angegebene Bedeutung hat.

**4.** Wäßrige Schlichtemittel für Glasfasern, enthaltend Filmbildner, Haftvermittler und gegebenenfalls weitere Zusatzstoffe, dadurch gekennzeichnet, daß die Schlichtemittel als Filmbildner wasserlösliche oder in Wasser dispergierbare Polymerharze gemäß Anspruch 1 bis 3 enthalten.

**5.** Geschlichtete Glasfasern, dadurch gekennzeichnet, daß die Glasfasern mit einem wäßrigen Schlichtemittel gemäß Anspruch 4 geschlichtet sind.

**6.** Flammwidrige Formmasse, welche
A) 30 bis 95 Gew.-% thermoplastisches oder duroplastisches Matrixpolymer,
B) 5 bis 70 Gew.-% beschlichtete Glasfasern gemäß Anspruch 5,
C) 0 bis 25 Gew.-% (bezogen auf das Matrixpolymer) eines oder mehrerer Flammschutzmittel und
D) 0 bis 10 Gew.-% übliche Zusatzstoffe und Hilfsmittel enthält,
wobei die Summe der Gewichtsprozente aus A), B), C) und D) zusammen 100 % ergibt.

**7.** Flammwidrige Formmasse gemäß Anspruch 6, dadurch gekennzeichnet, daß es sich bei dem Matrixpolymer um einen thermoplastischen aromatischen Polyester, um ein thermoplastisches aromatisches Polycarbonat, ein Polyamid oder ein duroplastisch härtbares Epoxidharz handelt.